# EUROPEAN PATENT APPLICATION

(11) **EP 0 608 515 A1**
(43) Date of publication of application: **03.08.1994**
(21) Application number: 93119440.1
(22) Date of filing: 02.12.1993
(51) Int. Cl.: H03K 19/0185

(54) **Programmable drive output buffer**

(30) Priority: 29.01.1993 US 10721
(71) Applicant: MOTOROLA, INC., Schaumburg, IL 60196 (US)
(72) Inventor: Tang, Dandas K., Tempe, Arizona 85283 (US); Sutton, Timothy W., Mesa, Arizona 85205 (US)
(74) Representative: Hudson, Peter David

(57) **Abstract**

A programmable drive output buffer for use in programmable logic devices has been provided. The programmable drive output buffer includes at least two pairs of output transistors (20,24-30,32) for providing current at a pad (12). The determination of whether each pair of output transistors are active is determined by a control signal (28) whose logic state is programmable by a user.

## Description

### Field of the Invention

This invention relates to output buffers and, in particular, to output buffers having programmable drive capability for use in programmable logic devices.

### Background of the Invention

Output drivers of existing programmable gate arrays usually have a fixed and typically high drive capability. However, if a user does not require a high drive capability on a certain pin, then a substantial waste in power consumption occurs. Thus, it would be advantageous to provide an output driver that has the flexibility of offering different drive capabilities depending upon the user application.

Hence, there exists a need for an improved output driver for use in programmable logic devices that has a programmable drive capability thereby allowing users to program a predetermined drive capability on an output buffer depending upon the specific application.

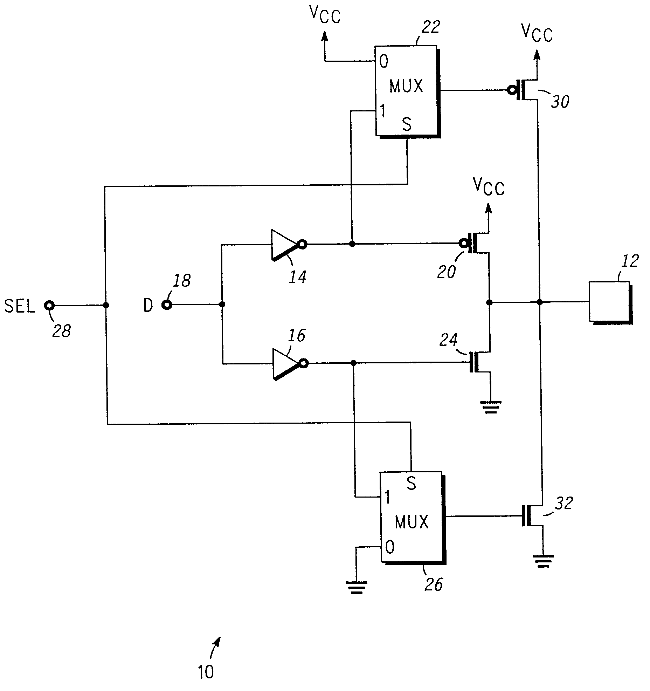

### Brief Description of the Drawing

The sole figure is a detailed schematic/block diagram of a programmable output driver for use in programmable logic devices in accordance with the present invention.

### Detailed Description of the Drawing

Referring to the sole figure, output driver 10 is shown for providing a programmable output drive current to a programmable logic device (PLD) pad/pin 12. Output driver 10 further includes pre-drivers 14 and 16, each having an input coupled to terminal 18 at which signal D is applied thereto. The output of pre-driver 14 is coupled both to the gate electrode of P-channel output transistor 20 and to a first input of multiplexer (MUX) 22.

The output of pre-driver 16 is coupled to a gate electrode of N-channel output transistor 24 and a first input of multiplexer (MUX) 26. The second input of multiplexer 22 is coupled to a first supply voltage terminal at which the operating potential V_{CC} is applied. The second input of multiplexer 26 is returned to ground reference.

The select inputs of multiplexers 22 and 26 are both coupled to terminal 28 at which control signal SEL is applied.

The output of multiplexer 22 is coupled to a gate electrode of P-channel output transistor 30 while the output of multiplexer 26 is coupled to a gate electrode of N-channel output transistor 32. The source electrodes of P-channel transistors 20 and 30 are coupled to receive operating potential V_{CC} while the source electrodes of N-channel transistors 24 and 32 are returned to ground.

The drain electrodes of transistors 20, 24, 30 and 32 are all coupled together and further coupled to pad 12. It is understood that transistor pair 20 and 24 comprise a first output driver circuit, while transistor pair 30 and 32 comprise a second output driver circuit.

In operation, multiplexer 22 is inserted between the output of pre-driver 14 and the gate electrode of P-channel output transistor 30. Likewise, multiplexer 26 is inserted between the output of pre-driver 16 and the gate electrode of N-channel output transistor 32. When control signal SEL is in a logic low state, voltage V_{CC} appears at the output of multiplexer 22 via the second input of MUX 22 thereby turning off transistor 30. In addition, the gate electrode of transistor 32 is returned to ground via the second input of MUX 26 thereby turning off transistor 32. As a result, output transistors 20 and 24 are the only active transistors utilized to provide current drive at pad 12.

On the other hand, when control signal SEL is in a logic high state, multiplexers 22 and 26 function to pass the signal appearing at its first input to its respective output. In particular, multiplexer 22 functions to couple the gate electrodes of transistors 20 and 30 together while multiplexer 26 functions to couple the gate electrodes of transistors 24 and 32 together. As a result, transistor 30 is essentially coupled in parallel with transistor 20, while transistor 32 is essentially coupled in parallel with transistor 24. Thus, transistors 20, 24, 30 and 32 are all available and active to provide current drive at pad 12 thereby allowing for higher current drive capability.

Thus, the present invention provides an output buffer for providing programmable drive capability wherein if transistors 30 and 32 are inactive then a first drive current is provided at pad 12 via active transistor pair 20 and 24. However, if output transistors 30 and 32 are activated, then a second drive current is provided at pad 12 via active transistor pairs 20 and 24, and 30 and 32. Further, it is important to realize that it is the logic state of signal SEL that determines whether the first or the second drive current is provided at pad 12. Moreover, this control signal is programmable via a storage device that already resides on a programmable logic device. As a result, by changing the contents of the storage device, the drive current provided at pad 12 can be changed by a user depending upon the application. This feature allows for programmable drive capability by a user in the field.

It should be clear that additional output driver circuits (similar to transistor pair 30 and 32) may be coupled in parallel in a similar manner as transistors 30 and 32 thereby providing for even more output current drive capability if so desired. Moreover, the control logic required to control these additional output driver circuits are programmable by a user via additional multiplexers similar to multiplexers 22 and 26.

By now it should be apparent from the foregoing discussion that a novel programmable drive output buffer for use in programmable logic devices has been provided. The programmable drive output buffer includes at least two pairs of output transistors for providing current at a pad. The determination of whether each pair of output transistors are active is determined by a control signal whose logic state is programmable by a user.

While the invention has been described in conjunction with specific embodiments thereof, it is evident that many alternations, modifications and variations will be apparent to those skilled in the art in the light of the foregoing description. Accordingly, it is intended to embrace all such alternations, modifications and variations in the appended claims.

## Claims

1. A programmable drive output buffer (10) for providing current drive to a pad (12) for use in programmable logic devices, comprising:
a first multiplexer circuit (22) having first and second inputs, a select input and an output, said first input of said first multiplexer circuit being coupled to receive a signal, said second input of said first multiplexer circuit being coupled to a first supply voltage terminal, said select input of said first multiplexer circuit being coupled to receive a control signal, said control signal having a logic state that is programmable by a user;
a second multiplexer circuit (26) having first and second inputs, a select input and an output, said first input of said second multiplexer circuit being coupled to receive said signal, said second input of said second multiplexer circuit being coupled to a second supply voltage terminal, said select input of said second multiplexer circuit being coupled to receive said control signal;
a first transistor driver circuit (20, 24) being coupled between said first and second supply voltage terminals and having first and second inputs and an output, said first and second inputs of said first transistor driver circuit being respectively coupled to receive said signal, said output of said first transistor driver circuit being coupled to the pad; and
at least one additional transistor driver circuit (30, 32) being coupled between said first and second supply voltage terminals and having first and second inputs and an output, said first and second inputs of said additional transistor driver circuit being respectively coupled to said outputs of said first and second multiplexer circuits, said output of said second transistor driver circuit being coupled to the pad.

2. The programmable drive output buffer according to claim 1 wherein said first transistor driver circuit includes:
a P-channel transistor (20) having first and second current carrying electrodes and a control electrode, said first current carrying electrode of said P-channel transistor being coupled to the pad, said second current carrying electrode of said P-channel transistor being coupled said first supply voltage terminal, said control electrode of said P-channel transistor being coupled to receive said signal; and
an N-channel transistor (24) having first and second current carrying electrodes and a control electrode, said first current carrying electrode of said N-channel transistor being coupled to the pad, said second current carrying electrode of said N-channel transistor being coupled to said second supply voltage terminal, said control electrode of said N-channel transistor being coupled to receive said signal.

3. The programmable drive output buffer according to claim 1 wherein said at least one additional transistor driver circuit includes:
a P-channel transistor (30) having first and second current carrying electrodes and a control electrode, said first current carrying electrode of said P-channel transistor being coupled to the pad, said second current carrying electrode of said P-channel transistor being coupled said first supply voltage terminal, said control electrode of said P-channel transistor being coupled to said output of said first multiplexer circuit; and
an N-channel transistor (32) having first and second current carrying electrodes and a control electrode, said first current carrying electrode of said N-channel transistor being coupled to the pad, said second current carrying electrode of said N-channel transistor being coupled to said second supply voltage terminal, said control electrode of said N-channel transistor being coupled to said output of said second multiplexer circuit.

4. The programmable drive output buffer according to claim 1 further including a pre-driver circuit (14, 16) having an input and first and second outputs, said input of said pre-driver circuit being coupled to receive said signal, said first and second outputs of said pre-driver circuit being respectively coupled to said first inputs of said first and second multiplexer circuits and to said first and second inputs of said first transistor driver circuit.

5. A programmable drive output buffer for providing current drive to a pad for use in programmable logic devices, comprising:
a first multiplexer (22) having first and second inputs, a select input and an output, said second input of said first multiplexer being coupled to a first supply voltage terminal, said select input of said first multiplexer being coupled to receive a control signal, said control signal having a logic state that is programmable by a user;
a second multiplexer (26) having first and second inputs, a select input and an output, said second input of said second multiplexer being coupled to a second supply voltage terminal, said select input of said second multiplexer being coupled to receive said control signal;
a first pre-driver (14) having an input and an output, said input of said first pre-driver being coupled to receive a signal, said output of said first pre-driver being coupled to said first input of said first multiplexer;
a second pre-driver (16) having an input and an output, said input of said second pre-driver being coupled to receive said signal, said output of said second pre-driver being coupled to said first input of said second multiplexer;
a first transistor driver (20, 24) being coupled between said first and second supply voltage terminals and having first and second inputs and an output, said first and second inputs of said first transistor driver being respectively coupled to said outputs of said first and second pre-drivers, said output of said first transistor driver being coupled to the pad; and
a second transistor driver (30, 32) being coupled between said first and second supply voltage terminals and having first and second inputs and an output, said first and second inputs of said second transistor driver being respectively coupled to said outputs of said first and second multiplexers, said output of said second transistor driver being coupled to the pad.

6. The programmable drive output buffer according to claim 5 wherein said first transistor driver includes:
a P-channel transistor (20) having first and second current carrying electrodes and a control electrode, said first current carrying electrode of said P-channel transistor being coupled to the pad, said second current carrying electrode of said P-channel transistor being coupled said first supply voltage terminal, said control electrode of said P-channel transistor being coupled to said output of said first pre-driver; and
an N-channel transistor (24) having first and second current carrying electrodes and a control electrode, said first current carrying electrode of said N-channel transistor being coupled to the pad, said second current carrying electrode of said N-channel transistor being coupled to said second supply voltage terminal, said control electrode of said N-channel transistor being coupled to said output of said second pre-driver.

7. The programmable drive output buffer according to claim 5 wherein said second transistor driver includes:
a P-channel transistor (30) having first and second current carrying electrodes and a control electrode, said first current carrying electrode of said P-channel transistor being coupled to the pad, said second current carrying electrode of said P-channel transistor being coupled said first supply voltage terminal, said control electrode of said P-channel transistor being coupled to said output of said first multiplexer; and
an N-channel transistor (32) having first and second current carrying electrodes and a control electrode, said first current carrying electrode of said N-channel transistor being coupled to the pad, said second current carrying electrode of said N-channel transistor being coupled to said second supply voltage terminal, said control electrode of said N-channel transistor being coupled to said output of said second multiplexer.
